# FASCICULE DE BREVET EUROPEEN

(11) **EP 0 208 673 B1**
(45) Date de publication et mention de la délivrance du brevet: **03.11.1993**
(21) Numéro de dépôt: 86870098.0
(22) Date de dépôt: 02.07.1986
(51) Int. Cl.: G01R 31/28

(54) **Equipement de test automatique**
Automatische Prüfvorrichtung
Automatic test equipment

(30) Priorité: 11.07.1985 BE 215322
(43) Date de publication de la demande: 14.01.1987
(73) Titulaire: CEGELEC ACEC S.A., B-6001 Marçinelle(Charleroi) (BE)
(72) Inventeur: Maret, Jean-Pol, B-6269 Roselies (BE)
(74) Mandataire: Van Malderen, Michel

(56) Documents cités:
- EP-A- 0 053 561
- DE-A- 3 136 813
- ELECTRONIC DESIGN, vol. 31, no. 7, 31 mars 1983, pages 151-156,158, Denvill, US; R. LENTO: "Single instrument automates all types of field tests"
- WESTERN ELECTRIC TECHNICAL DIGEST, no. 26, avril 1972, page 21, New York, US; D.C. COMEAU: "Testing system utilizing a resistor in a plug-in module specifically to identify the unit"
- IEE PROCEEDINGS SECTIONS A-I, vol. 131, no. 7, partie C, novembre 1984, pages 349-356, Old Woking, Surrey, GB; A. WILLIAMS et al.: "Method of using data from computer simulations to test protection equipment"
- AUTOTESTCON '83, Fort Worth, Texas, 1-3 novembre 1983, 83CH1968-7, pages 128-132, IEEE, New York, US; T.S. McNAMEE et al.: "Instrument-based test generation a cost-effective program development tool"

## Description

La présente invention a pour objet un équipement de test automatique comprenant une console d'exécution de tests équipée de générateurs de signaux et de moyens de détection et de mesures divers, pourvue de câbles ou bornes de raccordement , destinés à être reliés à des câbles ou bornes de connecteurs d'interface de test logés dans des armoires renfermant les appareils de mesure, de commande et/ou de contrôle d'une installation industrielle.

Dans de tels équipements en soi connus par exemple " Electronic Design " vol. 31 N° 7, 31 Mars 1983 pp 151 à 158, les bornes de raccordement de la console d'exécution de tests sont reliées à des circuits d'entrée ou de sortie logiques et/ou des circuits d'entrée ou de sortie analogiques équipés de convertisseurs analogique-numérique et numérique-analogique, ainsi que de dispositifs de multiplexage en ce qui concerne les circuits d'entrée analogiques ; la console d'exécution de tests comprend aussi une unité centrale à micro-calculateur reliée aux dits circuits d'entrée et de sortie et coopérant avec un programmeur et un ensemble mémoire dans lequel une mémoire morte renferme plusieurs successions automatiques d'ordres de tests et une nomenclature de messages stéréotypes relative aux dits ordres de tests, aux résultats possibles, et à une procédure conversationnelle de mise en condition de test ou de fonctionnement normal des armoires gouvernant l'installation industriel le complexe; la console d'exécution de tests comprend en outre un moyen de commande et /ou d'enregistrement, tel un téléimprimeur, relié à l'unité centrale, autorisant l'intervention d'un opérateur humain dans l'exécution des tests via l'unité centrale et les dits circuits d'entrée et de sortie, les liaisons entre unité centrale et circuits d'entrée et de sortie servant également à la transmission de signaux nécessaires à l'exécution des tests, la liaison entre le moyen d'enregistrement et l'unité centrale étant agencée pour appeler des successions d'ordres de test emmagasinés dans l'ensemble mémoire de l'unité centrale, et pour enregistrer, d'une part les appels d'ordres de test et d'autre part les résultats obtenus au moyen de la nomenclature enregistrée dans la mémoire morte.

L'équipement décrit dans cet article est un testeur portable destiné à effectuer divers types de tests sur des équipements définis relativement simples; son utilisation nécessite l'écriture par l'utilisateur d'un logiciel particulier avant de réaliser un test spécifique sur un équipement donné.

L'article de D.C.COMEAU intitulé "Testing system utilizing a resistor in a plug-in module specifically to identify the unit" publié dans WESTERN ELECTRIC TECHNICAL DIGEST, n° 26, avril 1972, page 21, New York décrit une méthode d'identification d'un module à tester par un équipement de test automatique quelconque. Cette méthode consiste à incorporer une résistance entre deux contacts du module pour l'identifier. Ces contacts sont connectés à des contacts de l'équipement de test, lequel est capable de mesurer la valeur de la résistance d'un module donné et de sélectionner un programme de test correspondant au module en question.

Le but de l'invention est un équipement de test pour des installations industrielles fonctionnant dans des conditions de sécurité très élevées capable d'exécuter des tests pendant le fonctionnement de l'installation et permettant d'effectuer de très grandes séries de tests variés d'une manière strictement identique et reproductible d'une fois à l'autre et avec une très grande rapidité. Le but principal est de prévenir, avec une perfection très grande, toutes les erreurs que pourraient commettre des opérateurs humains, grâce d'une part à une procédure conversationnelle de mise en condition de test des armoires gouvernant l'installation industrielle complexe et d'autre part à l'automatisation presque complète de l'exécution des tests.

Suivant un autre but, les tests envisagés concernent non seulement la transmission et l'affichage fidèle des valeurs mesurées ou calculées et le fonctionnement correct des différents éléments des circuits, mais aussi la reproductibilité dans d'étroites limites du comportement dynamique des chaînes de commande et/ou de certaines parties de celles-ci.

L'équipement doit permettre l'exécution de tests périodiques dans des installations industrielles complexes, par exemple dans des centrales thermiques ou nucléaires dans lesquelles les temps des tests doivent être réduits à un minimum, afin de garantir une disponibilité maximum des divers ensembles à tester de l'installation industrielle.

Un autre but très important est un équipement de test fournissant des protocoles de tests détaillés, absolument complets, aussi bien dans ses parties standardisées que dans les parties relevant d'interventions spontanées d'un opérateur. Les protocoles de test doivent mentionner non seulement les résultats de mesures de précision et des constats d'irrégularités faits pendant les tests mais également toutes les vérifications mineures exécutées et n'ayant pas donné occasion à faire des remarques.

L'invention est caractérisée en ce que d'une part, le connecteur d'interface logé dans chaque armoire gouvernant l'installation industrielle ou sous-ensemble d'une telle installation comprend , outre les contacts de transmission de signaux relatifs aux tests proprement dits , et de contacts réservés à un codage d'identification de l'armoire ou sous-ensemble, au moins un moyen de contrôle de la position d'au moins un appareil de commande de mise en condition de test ou de fonctionnement normal, fournissant à la console d'exécution de tests via le connecteur d'interface, des signaux influençant la procédure conversationnelle et conditionnant l'exécution des tests et la remise en état de fonctionnement normal, ces signaux comprenant des signaux logiques
- du code binaire d'identification d'une armoire à tester
- du module de test de la chaîne ou partie de chaîne de protection à tester.

Il est possible que certains moyens de contrôle soient également accessibles à des signaux de commande émanant de la console de test, susceptibles d'opérer des changements de conditions de fonctionnement à l'intérieur de l'armoire gouvernant l'installation industrielle.

L'invention est expliquée ci-dessous à l'aide d'un exemple en se référant au dessin annexé. La figure 1 du dessin est un schéma bloc dans lequel figurent les éléments principaux de l'équipement suivant l'invention. la figure 2 est un diagramme de tension d'essai en fonction du temps. Les figures 3 et 4 sont des schémas de dispositions de tests particuliers.

L'équipement de test suivant l'invention peut être une console montée sur un châssis mobile, non représentée, équipée par exemple de roulettes. Elle comprend plusieurs casiers et panneaux renfermant ou supportant ses différents éléments.

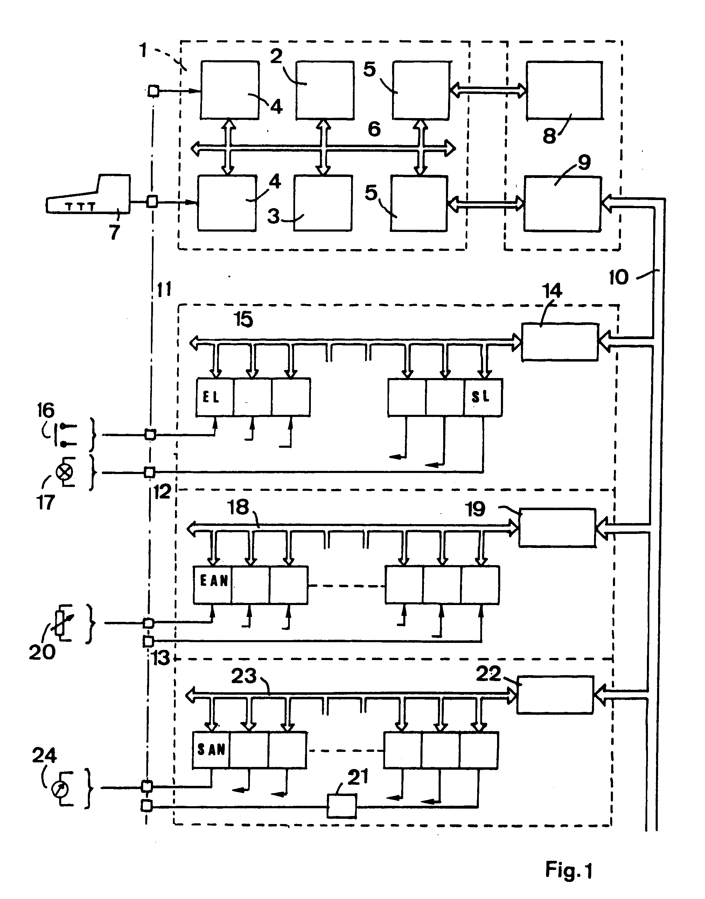

Selon la figure 1, un casier 1 renferme un microcalculateur 2 composé d'un micro-calculateur proprement dit par exemple du type INTEL 8085A et de ses mémoires associées, par exemple EPROM type 2732 ou 2764 et 4 K octets de mémoire RAM, une mémoire de programme 3 composée par exemple par une carte possédant 16 emplacements pour des mémoires EPROM 2716 et d'un programmeur EPROM accessible par exemple à la face avant de la console. Les mémoires EPROM renferment notamment des ordres d'exécution de tests, les données de contrôle de sécurité d'exécution des tests et une nomenclature de messages appropriée à la procédure conversationnelle de mise en condition et d'exécution des tests et d'enregistrement des résultats. le casier 1 renferme en outre au moins un module 4 d'interface de mode série par exemple un module USART, type 8251A et au moins un module 5 d'interface de mode parallèle. Les modules 4 d'interface de mode série transforment des données livrées simultanément sur plusieurs voies de communication en une série unique de données livrées sur un seul conducteur ou voie de communication et, en sens inverse, transforment une série d'informations unique en plusieurs séries d'informations véhiculées simultanément sur plusieurs voies de communication. Ces transformations sont effectuées notamment grâce à l'intervention d'éléments d'adressage contenus ou introduits dans les informations véhiculées et de mémoires tampon dans les modules d'interface. Un des modules d'interface 4 de mode série permet d'établir notamment la liaison avec le téléimprimeur 7 ou un autre moyen d'enregistrement et de commande.

Les modules d'interface de mode parallèle 5 peuvent être par exemple de simples mémoires tampon associées à des discriminateurs d'adresse en nombre égal au nombre des voies de communications. Lesliaisons entre les éléments 2 à 5 de l'unité centrale sont réalisées, en l'occurrence, au moyen d'un ensemble de conducteurs appelé " bus de micro-calculateur " 6.

Les modules d'interface parallèle 5 permettent d'établir la liaison avec d'une part des dispositifs d'alarme 8 et/ou générateurs de consigne et d'autre part un séparateur 9 pour un bus 10, dit " industriel " établissant la liaison avec des connecteurs d'interface 11 à 13 pour périphériques dans des armoires gouvernant l'installation industrielle. Le séparateur 9 n'est pas indispensable, car le bus industriel 10 pourrait être relié directement au module d'interface 5. Toutefois, le séparateur permet de fonctionner avec des tensions sensiblement plus élevées (par exemple 24 V) dans le bus industriel 10 que la valeur de la tension utilisée dans le bus micro-calculateur 6, (par exemple 6 V), ce qui améliore la protection contre l'apparition de signaux parasites.

A la figure 1, trois sortes de connecteurs d'interface 11 à 13 sont représentés à titre d'aide mémoire. En fait, l'équipement de test suivant l'invention peut comprendre un nombre différent de chacun des connecteurs d'interface 11 à 13. Ces connecteurs d'interface sont reliés aux armoires gouvernant l'installation industrielle par un câble à extrémités enfichables à conducteurs multiples. (Par exemple, en l'occurrence, un câble à 96 conducteurs).

Un connecteur 11 comprend, en l'occurence, 8 sorties logiques (SL) et 8 entrées logiques (EL). Chaque sortie logique comprend un contact NO entre deux bornes correspondantes commandé au moyen d'un relais par un signal de commande émis par un dispositif d'interface logique 14. Le dispositif 14 reçoit, via le bus 10, un ordre provenant de l'unité centrale dans le casier 1 et émet un courant de commande pour le relais correspondant à cet ordre via un bus 15 interne du connecteur 11. Chaque paire de bornes correspondantes est indépendante des autres paires grâce au relais comprenant le contact NO.

Chaque entrée logique comprend par exemple une diode photo-électrique entre deux bornes correspondantes coopérant avec un récepteur de lumière approprié. Cette disposition garantit l'isolation galvanique des entrées l'une par rapport à l'autre.

Dans l'armoire gouvernant le processus industriel complexe, une entrée logique transmise par le connecteur d'interface est reliée par exemple à un contact 16 dont il faut contrôler l'ouverture ou la fermeture, tandis qu'une sortie logique peut être raccordée par exemple à un circuit d'alimentation d'une lampe de signalisation dont on doit surveiller le fonctionnement. Ceci est figuré par des symboles conventionnels respectivement 16 et 17 sur la figure 1.

Le connecteur 12 représente un connecteur d'entrées anologiques (E AN). Chacune des entrées individuelles (en l'occurrence 8) accepte des tensions, par exemple dans la gamme de -10V à +10V, et est reliée à un filtre passe-bas qui élimine des composantes alternatives parasites éventuelles en mode différentiel (avec par exemple une constante de temps de l'ordre de 50 ms). Les différentes entrées analogiques sont reliées au moyen d'un bus interne 18 à un dispositif d'interface analogique d'entrée 19 qui assure les échanges de données entre l'unité centrale dans le casier 1 au moyen d'un dispositif de multiplexage, d'un convertisseur analogique-numérique et d'un dispositif d'adressage et de commande des séquences d'acquisition de valeurs multiplexées. Une entrée analogique peut recevoir, par exemple, une tension aux bornes d'une résistance 20 dans l'armoire gouvernant l'installation industrielle.

Le connecteur 13 représente un connecteur de sorties analogiques (S AN) ; chaque sortie individuelle permet la conversion d'un mot de par exemple 12 bits, généré par l'unité centrale, en une grandeur analogique de sortie. Cette grandeur peut être notamment une tension. Si la grandeur de sortie doit être un courant un convertisseur tension-courant 21 peut être raccordé. Un dispositif d'interface analogique de sortie 22 permet d'établir la liaison entre le bus industriel 10 et un bus interne 23 relié aux sorties individuelles (S AN). Le dispositif d'interface analogique 22 comprend notamment un décodeur d'adresse et éventuellement des amplificateurs. Une sortie analogique peut tester par exemple un voltmètre 24 dans l'armoire gouvernant l'installation industrielle complexe.

Au niveau de l'appareillage de commande gouvernant le processus industriel par exemple trois chaînes de commande de sécurité redondantes sont prévues fonctionnant simultanément, reliées en fin de compte à un circuit de votation 2/3. Pendant les tests, une seule chaîne est testée. Le test n'est exécuté que dans le cas où le bon fonctionnement des deux autres chaînes peut être raisonnablement supposé. Chaque chaîne est disposée dans une armoire séparée. Chaque armoire est équipée d'un module de test constitué dans l'essentiel par un ensemble commutateur qui en position de test met les sorties dé connectées des comparateurs en position de sécurité, c'est-à-dire en position alarme, débranche les capteurs des grandeurs mesurées du circuit normal et introduit, à la place des signaux émis par les capteurs, des signaux de test, simulant les signaux des capteurs, engendrés dans l'équipement de test. Cet ensemble commutateur comprend un moyen, par exemple un contact 16, contrôlant la position de l'ensemble pour déterminer s'il se trouve en condition de test ou de fonctionnement normal. La procédure conversationnelle est essentiellement influencée par la constatation que l'armoire à tester est commutée en condition de test et le test ne peut être exécuté en l'absence de cette constatation. L'armoire est identifiée au moyen d'un numéro de codage dont les bits apparaissent sur un certain nombre de bornes auxquelles est raccordé le connecteur d'interface.

Pendant un test, l'installation industriel le fonctionne donc avec une sécurité moindre, assurée par deux chaînes seulement et le circuit de votation 2/3 fonctionne, dans ce cas, comme un circuit de votation 1/2, c'est-à-dire une fausse alarme risque plus facilement de se déclencher.

Pour chaque test effectué par l'équipement de test automatique, le téléimprimeur enregistre un code identifiant la chaîne et/ou le comparateur testés, ainsi que le résultat du test, suivi du constat de conformité, en notant, par exemple OK si le fonctionnement est correct ou en reproduisant un message d'erreur spécifique au défaut constaté extrait de la nomenclature emmagasinée.

Au niveau logiciel, une procédure de conversation entre opérateur et équipement de test automatique est prévue, permettant de garantir une mise en configuration d'essai de sécurité de l'appareillage de commande gouvernant le processus industriel. Pour chacune des chaînes à tester l'équipement de test automatique possède en mémoire les données caractéristiques à surveiller avant le commencement du test et lors de la commutation inverse qui rétablit le fonctionnement normal de l'appareillage de commande gouvernant le processus industriel . Le fonctionnement d'une alarme peut être prévu si le connecteur d'interface est retiré sans que l'armoire se trouve en condition de fonctionnement normal.

Chaque test relatif à une chaîne implique l'enregistrement automatique d'un compte-rendu de test propre au schéma fonctionnel de la chaîne et au type de test exécuté. La nomenclature des messages caractéristiques pouvant figurer dans le compte-rendu sont emmagasinées en mémoire EPROM au niveau de l'unité centrale dans le casier 1.

L'exécution d'un test a lieu après la sélection de la série de tests propre à une chaîne déterminée et le transfert en mémoire RAM de la nomenclature correspondante en vue du compte-rendu.

Au niveau matériel et logiciel, l'équipement de test dispose aussi de moyens nécessaires au contrôle de ses propres modules fonctionnels, c'est-à-dire notamment les entrées et sorties logiques, les entrées analogiques, les sorties analogiques, les résistances de précision, les convertisseurs tension-courant. Ces contrôles sont normalement effectués en dehors du temps de test proprement dit. Le programme des contrôles peut vérifier aussi le contenu des mémoires EPROM et mettre en évidence une éventuelle détérioration de celui-ci.

Une procédure programmée appelée "debug" peut être prévue à l'usage des informaticiens pour permettre d'intervenir et de faire des diagnostiques au niveau de manipulations relatives aux mémoires EPROM et RAM, concernant la lecture, l'écriture, la vérification et la programmation des mémoires EPROM existantes ou nouvellement ajoutées.

L'équipement spécifique de test est composé de plusieurs unités particulières destinées chacune à effectuer des tests sur des éléments contenus dans les armoires gouvernant le processus industriel complexe.

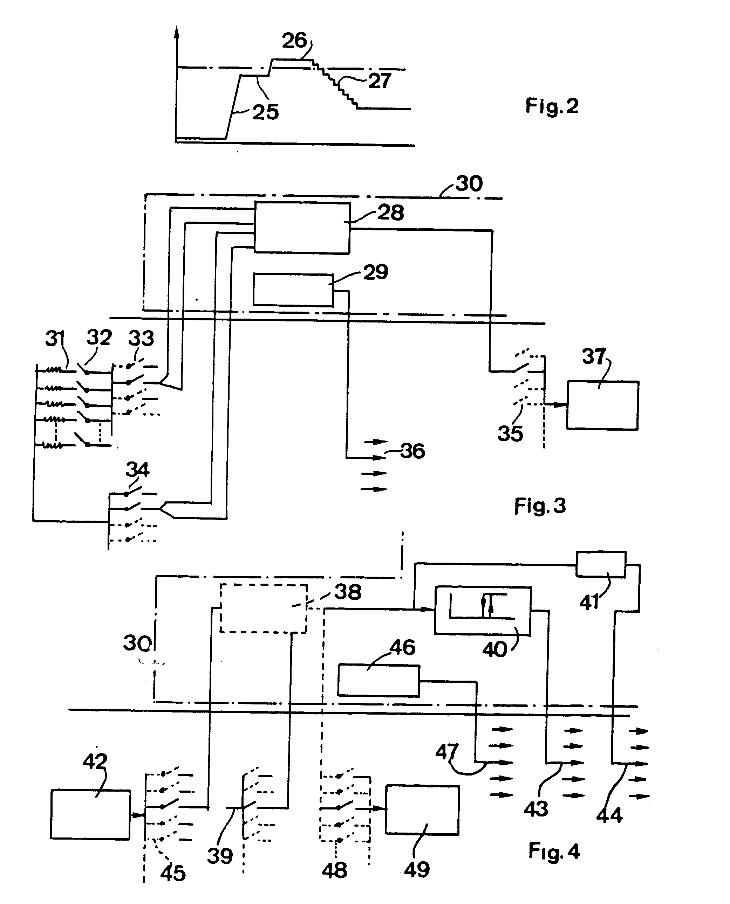

Une première telle unité particulière permet de tester le fonctionnement de dispositifs à seuil, associés à un comparateur. Elle comprend une ou plusieurs entrées de courant ou de tension et contrôle les signaux de sortie du comparateur. L'équipement de test possède, enregistrées dans l'ensemble mémoire de l'unité centrale, les données concernant les caractéristiques de chaque dispositif à seuil qui doit être testé. L'explication suivante de l'exécution du test se réfère à un diagramme figure 2 dans lequel la tension appliquée au dispositif à seuil est portée en fonction du temps de test. Après identification du dispositif à tester, l'unité centrale engendre, à l'endroit d'une sortie analogique, un courant ou une tension maintenu au niveau d'une limite haute 25 c'est-à-dire en dessous du seuil dans le cas d'une alarme haute (limite basse au dessus du seuil dans le cas d'une alarme basse) et l'applique au dispositif à tester pendant un temps suffisant pour contrôler l'absence d'alarme, ce qui est vérifié par l'introduction du signal de sortie du comparateur dans une entrée logique. Si le déclenchement d'une alarme est constaté au niveau de cette entrée logique, le fonctionnement du dispositif testé est incorrect, le téléimprimeur enregistre un message correspondant et la succession des autres ordres de test relatifs à ce dispositif à tester est supprimé. Si au contraire, on constate que le dispositif à tester répond correctement, un message correspondant est enregistré par le téléimprimeur et on passe, en un échelon au niveau d'une limite basse 26 au dessus du seuil (limite haute, en dessous du seuil dans le cas d'une alarme basse) pendant un temps suffisant pour vérifier l'enclenchement d'une alarme. Dans le cas d'un fonctionnement incorrect (absence d'alarme), un message correspondant est enregistré par le téléimprimeur et le test relatif à ce dispositif est terminé. Si au contraire, on constate un fonctionnement correct, un message correspondant est imprimé et on passe par échelons successifs 27 de l'autre côté du seuil jusqu'à ce que l'état d'alarme disparaisse à l'entrée logique servant de détecteur. On vérifie au niveau de l'unité centrale que ce changement d'état intervient dans un laps de temps inférieur à une limite déterminée, par exemple 20 ms. Dans le cas d'un fonctionnement correct on voit apparaître l'impression du message : OK. Dans le cas d'un fonctionnement incorrect, ce dernier test est recommencé en portant le laps de temps limite à par exemple 4 fois sa valeur originale. Si l'alarme disparaît, le protocole comprend le message " temps de réponse trop long ". Si l'alarme ne disparaît pas dans ce temps allongé, le message " pas de changement d'état " apparaît.

L'unité décrite ci-dessus est du type simple. D'autres unités semblables à cette première unité, mais du type complexe peuvent permettre de tester des dispositifs à seuil à plusieurs entrées. Lors de chaque test une seule des entrées est variable, les autres entrées sont maintenues fixes.

Une deuxième unité particulière permet de tester des parties d'une chaîne de protection servant à la transmission de valeurs de grandeurs mesurées, par exemple de valeurs de température. Le schéma de principe de cette unité particulière et de son fonctionnement est représenté à la figure 3. La partie 28 d'une chaîne de protection à tester servant à la transmission des valeurs d'une grandeur mesurée est ici, en l'occurrence, un transmetteur de température à quatre fils d'entrée. Un module de test 29, actionné à la main permet de déconnecter la partie de chaîne à tester et d'établir les liaisons représentées à la figure 3. Les éléments 28 et 29 représentés dans le cadre en lignes interrompues 30 se trouvent dans l'armoire gouvernant l'installation industrielle complexe. Les autres éléments se trouvent dans la console de test. Parmi ces autres éléments se trouve notamment un jeu de résistances 31 coopérant avec un jeu de contacts de sélection 32 permettant de simuler diverses valeurs de résistance d'un capteur de température déconnecté. Le jeu de résistances 31 et le jeu de contacts 32, qui sont des contacts de sortie logiques actionnés par l'unité centrale constituent en fait un générateur de signaux de mesure simulés. La disposition montrée à la figure 3 permet de tester l'une après l'autre plusieurs parties 28 de chaînes de protection, en l'occurence plusieurs transmetteurs de température, au moyen de contacts fixes de sélecteur 33, 34 et 35 reliés simultanément au connecteur d'interface. Les contacts mobiles de ces sélecteurs sont des contacts de sortie logiques actionnés par l'unité centrale. Les contacts de sélecteur 33 et 34 établissent les connections en amont d'un transmetteur de température 28, les contacts de sélecteur 35 celles en aval. Le module de test 29 actionné à la main est relié à la console au moyen d'un conducteur appliqué à une entrée logique 36 permettant de surveiller si ce module 29 se trouve en position de test ou en position normale de fonctionnement. Le signal à l'entrée logique 36 peut permettre ou interdire l'exécution du test. Les signaux de sortie du transmetteur de température 28, sélectionnés par les contacts du sélecteur 35 sont appliqués ensuite à une entrée analogique 37 servant d'appareil de mesure et finalement comparés dans l'unité centrale, à des valeurs théoriques correspondant aux valeurs d'entrée sélectionnées par le sélecteur 35, en fonction d'ordres provenant de l'unité centrale, exécutés au moyen de contacts de sélection 32. Chaque série de tests concerne plusieurs valeurs de résistance choisies dans la gamme de variation normale du capteur, simulées par les résistances 31 sélectionnées.

Le protocole de test donne les résultats sous forme de tableau où figurent dans une première colonne les valeurs théoriques dans une deuxième colonne les valeurs mesurées à l'endroit de l'entrée analogique 37 et dans une troisième colonne le message " OK " si l'écart entre les valeurs des deux premières colonnes est inférieur à la tolérance admise ou un message caractérisant la nature de l'irrégularité.

Une troisième unité particulière permet de tester en temps réel un comportement dynamique ou une fonction de transfert d'une chaîne ou d'une partie de chaîne. Un exemple est représenté à la figure 4. Une partie de chaîne 38 comprenant des éléments à comportement dynamique, par exemple des intégrateurs, dispositifs de dérivation, circuits de retard etc. doit comprendre des éléments de commande particuliers par exemple commutateurs permettant d'exécuter les tests d'une part sur les parties de circuit à transfert proportionnel et d'autre part sur les parties de circuit à comportement dynamique. Dans ce but, un signal de polarisation ou de zérotage du module dynamique livré par une sortie logique 39 et transmis au moyen d'un conducteur de transmission de commande à un commutateur dans la partie 38 peut éliminer le comportement dynamique de la partie de chaîne 38 à tester et permettre, dans un premier temps, de contrôler le bon fonctionnement de la composante proportionnelle de la chaîne qui peut comprendre un ou plusieurs comparateurs 40, 41. Lors de ce premier temps une sortie analogique 42 fournit une tension telle que représentée par exemple à la figure 2, tandis que des entrées logiques 43 et 44 contôlent l'apparition de signaux de sortie corrects des comparateurs 40,41.

Après ce test préalable, le zérotage de la partie de chaîne à tester 38 est supprimé en ouvrant le contact de la sortie logique 39 et une tension en forme de rampe est engendrée dans la sortie analogique 42 qui sert de générateur de tension de test. Le moment de démarrage de la rampe coïncide avec le moment de fermeture du contact d'une sortie logique 45 en aval de la sortie analogique 42. A ce même moment, la simulation du comportement dynamique de la partie de chaîne 38, convenablement identifiée grâce à un module de test 46 appliqué à une entrée logique 47, a lieu en temps réel dans l'unité centrale. La sortie de la partie de chaîne 38 est appliquée via une sortie logique 48 à une entrée analogique 49 servant d'appareil de mesure de manière à être analysée par comparaison avec le comportement dynamique simulé dans l'unité centrale. Cette comparaison est effectuée pour un nombre de points relativement grand par exemple 300 points en l'espace de 30 secondes. Dans le cas où la différence entre la fonction réelle et la fonction théorique, calculée ne dépasse pas des écarts de tolérance admis, le protocole enregistre un message " dynamique OK ". Dans le cas contraire, le message est " dynamique problèmatique ".

La mise en condition de test d'une armoire ou partie d'armoire implique le raccordement des câbles et la manipulation des modules de test accessibles sur les panneaux avant des armoires par l'opérateur. Cependant, toutes ces manipulations sont contrôlées par la console de test grâce à un programme conversationnel indiquant les opérations manuelles à exécuter et surveillant la réalisation des connexions ainsi ordonnées. L'exécution des tests est empêchée si toutes les conditions nécessaires ne sont pas remplies. Il en est de même lors de l'opération inverse qui consiste à mettre l'armoire en fonctionnement normal.

## Revendications

1. Equipement de test automatique comprenant une console d'exécution de tests équipée de générateurs de signaux et de moyens de détection et de mesure divers, pourvue de câbles ou bornes de raccordement, destinés à être reliés à des câbles ou bornes de connecteurs d'interface (11,12,13) de test logés dans des armoires renfermant les appareils de mesure, de commande et/ou de contrôle d'une installation industrielle, console d'exécution de tests dans laquelle les bornes de raccordement sont reliées à des circuits d'entrée ou de sortie logiques et/ou des circuits d'entrée ou de sortie analogiques équipés de convertisseurs analogique-numérique et numérique-analogique, ainsi que de dispositifs de multiplexage en ce qui concerne les circuits d'entrée analogiques; dans laquelle une unité centrale à micro-calculateur (2) est reliée aux dits circuits d'entrée et de sortie et coopère avec un programmeur et un ensemble mémoire (3) dans lequel une mémoire morte renferme plusieurs successions automatiques d'ordres de tests et une nomenclature de messages stéréotypes relative aux dits ordres de tests, aux résultats possibles, et à une procédure conversationnelle de mise en condition de test ou de fonctionnement normal des armoires gouvernant l'installation industrielle complexe; dans laquelle un moyen de commande et/ou d'enregistrement, tel un téléimprimeur (7) est relié à l'unité centrale, autorisant l'intervention d'un opérateur humain dans l'exécution des tests via l'unité centrale et les dits circuits d'entrée et de sortie, les liaisons entre unité centrale et circuits d'entrée et de sortie servant également à la transmission de signaux nécessaires à l'exécution des tests, la liaison entre le moyen d'enregistrement et l'unité centrale étant agencée pour appeler des successions d'ordres de test emmagasinés dans l'ensemble mémoire de l'unité centrale et pour enregistrer, d'une part les appels d'ordres de test et d'autre part les résultats obtenus, au moyen de la nomenclature enregistrée dans la mémoire morte, caractérisé en ce que le connecteur d'interface logé dans chaque armoire gouvernant l'installation industrielle ou sous-ensemble d'une telle installation comprend, outre les contacts de transmission de signaux relatifs au tests proprement dits, et les contacts réservés à un codage d'identification de l'armoire ou sous-ensemble, au moins un moyen de contrôle (16,29) de la position d'au moins un appareil de commande de mise en condition de test ou de fonctionnement normal fournissant à la console d'exécution des tests via le connecteur d'interface, des signaux influençant la procédure conversationnelle et conditionnant l'exécution des tests et la remise en état de fonctionnement normal, ces signaux comprenant des signaux logiques
- du code binaire d'identification d'une armoire à tester
- du module de test de la chaîne ou partie de chaîne de protection à tester.

2. Equipement automatique suivant la revendication 1, caractérisé en ce qu'il comprend au moins une unité de test particulière comprenant l'enregistrement dans l'ensemble mémoire (2) des caractéristiques particulières d'au moins un dispositif à seuil associé à un comparateur et un générateur de signal de test émettant un signal maintenu au niveau d'une limite haute, en-dessous du seuil (limite basse au-dessus du seuil) pendant un temps suffisant pour contrôler l'absence d'alarme, maintenu ensuite au niveau d'une limite basse au-dessus du seuil (limite haute en-dessous du seuil) un temps suffisant pour contrôler, par l'intermédiaire d'une entrée logique, l'enclenchement d'alarme et passant ensuite par échelons successifs de l'autre côté du seuil en contrôlant que l'état d'alarme disparaisse au cours d'un laps de temps prédéterminé.

3. Equipement automatique suivant une des revendications 1 ou 2, caractérisé en ce qu'il comprend au moins une unité de test particulière comprenant l'enregistrement dans l'ensemble mémoire des caractéristiques particulières d'au moins une partie (28) d'une chaîne de protection servant à la transmission de valeurs d'une grandeur mesurée, un générateur (31,32) de valeurs de mesure simulées, et une entrée analogique (37) servant d'appareil de mesure de la valeur de sortie de la dite partie (28) de la chaîne de protection.

4. Equipement automatique suivant la revendication 3, caractérisé en ce que le générateur de valeurs simulées est un sélecteur (32) sélectionnant des valeurs de résistances (31) et en ce que des sélecteurs (33,34,35) de différentes parties (28) d'une chaîne de protection permettent de tester l'une après l'autre de ces parties (28).

5. Equipement suivant une des revendications précédentes, caractérisé en ce qu'il comprend au moins une unité de test particulière comprenant l'enregistrement dans l'ensemble mémoire des caractéristiques particulières d'au moins une partie (38) d'une chaîne de protection présentant un comportement dynamique, au moins un conducteur reliant la partie de chaîne à tester à un contact de transmission de commande (39) agencé pour être connecté à la console de tests automatique, une sortie analogique (42) servant de générateur d'une tension de test, une entrée analogique (49) servant d'appareil de mesure en temps réel et des entrées logiques (43,44) servant de détecteurs en temps réel de comparateurs associés à la partie de chaîne à tester.

6. Equipement suivant une des revendications précédentes, caractérisé en ce qu'un moyen de commande (39) de la console d'exécution de tests provoque une modification de circuit dans une partie (38) d'une chaîne de protection dans une armoire gouvernant l'installation à tester.

## Claims

1. Automatic test equipment comprising a test performance console equipped with signal generators and various detection and measurement means, provided with connecting cables or terminals, intended to be connected to cables or terminals of test interface connectors (11, 12, 13) housed in cabinets containing the measurement, control and/or regulating apparatus of an industrial installation, in which test performance console the connecting terminals are connected to digital input or output circuits and/or analog input or output circuits equipped with analog-to-digital and digital-to-analog converters, and also multiplexing devices with respect to the analog input circuits; in which a central unit having a micro-computer (2) is connected to said input and output circuits and cooperates with a programmer and a memory unit (3) in which a read-only memory contains several automatic sequences of test instructions and a nomenclature of stereotype messages relating to said test instructions, to the possible results, and to a conversational procedure for bringing the cabinets governing the complex industrial installation into the test or normal operating condition; in which a control and/or recording means, such as a teleprinter (7), is connected to the central unit, authorising the intervention of a human operator in the performance of the tests via the central unit and said input and output circuits, the links between the central unit and the input and output circuits also being used for the transmission of signals necessary for the performance of the tests, the link between the recording means and the central unit being designed to retrieve sequences of test instructions stored in the memory unit of the central unit and to record firstly the calls on test instructions and secondly the results obtained, by means of the nomenclature recorded in the read-only memory,
**characterised in that** the interface connector housed in each cabinet governing the industrial installation or partial assembly of such an installation comprises, in addition to the signal transmission contacts relating to the tests in the true sense of the word, and the contacts reserved for a coding identifying the cabinet or partial assembly, at least one means (16, 29) for regulating the position of at least one control appliance for achieving the test or normal operating condition, supplying the test performance console via the interface connector with signals influencing the conversational procedure and conditioning the performance of the tests and the return to the normal operating state, these signals comprising digital signals
- of the binary identification code of a cabinet to be tested
- of the test mode of the system or system part to be tested.

2. Automatic equipment according to Claim 1,
**characterised in that** it comprises at least one special test unit comprising the recording in the memory unit (2) of the special characteristics of at least one threshold device associated with a comparator and a test signal generator emitting a signal kept at the level of a high limit, beneath the threshold (low limit above the threshold) for a time adequate for monitoring the absence of an alarm, then kept at the level of a low limit above the threshold (high limit beneath the threshold) for a time adequate for monitoring, by means of a digital input device, the activation of an alarm and then passing by successive steps to the other side of the threshold by monitoring that the state of alarm disappears during a predetermined period of time.

3. Automatic equipment according to one of Claims 1 or 2,
**characterised in that** it comprises at least one special test unit comprising the recording in the memory unit of special characteristics of at least one part (28) of a protection system used for the transmission of values of a measured variable, a generator (31, 32) of simulated measurement values, and an analog input device (37) used as an appliance for measuring the output value of said part (28) of the protection system.

4. Automatic equipment according to Claim 3,
**characterised in that** the generator of simulated values is a selector (32) selecting values of resistors (31), **and in that** selectors (33, 34, 35) of different parts (28) of a protection system enable these parts (28) to be tested one after the other.

5. Equipment according to one of the preceding Claims,
**characterised in that** it comprises at least one special test unit comprising the recording in the memory unit of the special characteristics of at least one part (38) of a protection system having a dynamic behaviour, at least one conductor connecting the system part to be tested to a transmission control contact (39) designed to be connected to the automatic test console, an analog output device (42) used as a test voltage generator, an analog input device (49) used as measurement appliance in real time and digital input devices (43, 44) used as detectors in real time of comparators associated with the system part to be tested.

6. Equipment according to one of the preceding Claims,
**characterised in that** a control means (39) for the test performance console brings about a circuit modification in one part (38) of a protection system in a cabinet governing the installation to be tested.

## Patentansprüche

1. Automatische Prüfvorrichtung, enthaltend eine Prüfkonsole, welche mit Signalgeneratoren und verschiedenen Erfassungs- und Meßeinrichtungen und mit Kabeln oder Anschlüssen zur Verbindungsherstellung ausgerüstet ist, die dazu bestimmt sind an die Kabel oder Anschlüsse von Prüf-Schnittstellenverbindern angeschlossen zu werden, welche in Schränken, die die Geräte zur Messung, zur Steuerung und/oder zur Kontrolle einer Industrieanlage enthalten, angeordnet sind, wobei die Prüfkonsole enthält: Anschlüsse zur Verbindungsherstellung die an logische Eingangs- oder Ausgangsschaltungen und/oder analoge Eingangs- oder Ausgangsschaltungen angeschlossen sind, welche mit Analog-Digital-Wandlern und mit Digital-Analog-Wandlern, sowie, was die analogen Eingangsschaltungen anlangt, mit Multiplexvorrichtungen ausgerüstet sind; eine Mikrorechner-Zentraleinheit (2), die mit diesen Eintritts- und Ausgangsschaltungen verbunden ist und die mit einem Programmierer und einer Speichereinheit (3) zusammenwirkt, in der ein Festspeicher mehrere automatische Folgen von prüfbefehlen und eine Nomenklatur von stereotypen Meldungen enthält, die sich auf diese Prüfbefehle, auf die möglichen Ergebnisse und auf eine Dialogprozedur zur Herstellung des Prüf- oder Normalbetriebzustands der die komplexe Industrieanlage steuernden Schränke bezieht; und eine Steuer- und/oder Aufzeichnungseinrichtung wie ein Ferndrucker (7) mit der Zentraleinheit verbunden, der das Eingreifen eines menschlichen Operators in die Durchführung der Prüfungen über die Zentraleinheit und diese Eingangs- und Ausgangsschaltungen zuläßt, wobei die Verbindungen zwischen Zentraleinheit und Eingangs- und Ausgangsschaltungen außerdem zur Übertragung von für die Durchführung der Prüfungen erforderlichen Signalen dienen und die Verbindung zwischen der Aufzeichnungseinrichtung und der Zentraleinheit so ausgebildet ist, daß in der Speichereinheit der Zentraleinheit gespeicherte Prüfbefehlsfolgen aufgerufen werden und einerseits die prüfbefehlsaufrufe und andererseits die erhaltenen Ergebnisse mit Hilfe der im Festspeicher gespeicherten Nomenklatur aufgezeichnet werden,
***dadurch gekennzeichnet, daß*** der Schnittstellenverbinder, der in jedem die Industrieanlage oder eine Untereinheit einer solchen Anlage steuernden Schrank angeordnet ist, abgesehen von den Kontakten zur Übertragung von die eigentlichen Prüfungen betreffenden Signalen und den für eine Kodierung zur Kennzeichnung des Schranks oder der Untereinheit vorbehaltenen Kontakten, wenigstens eine Einrichtung (16, 29) zur Kontrolle der Stellung wenigstens einer Steuervorrichtung zur Herstellung des Prüfzustands oder des Normalbetriebszustands umfaßt, die der Prüfkonsole über den Schnittstellenverbinder Signale liefert, die die Dialogprozedur beeinflussen und die Ausführung der Prüfungen und die Rückstellung in den Normalbetriebszustand bedingen, wobei diese Signale logische Signale
- vom Binärcode zur Kennzeichnung eines zu prüfenden Schranks
- des Moduls zur Prüfung der zu prüfenden Kette oder des zu prüfenden Schutzkettenteils umfassen.

2. Automatische Vorrichtung nach Anspruch 1,
***dadurch gekennzeichnet, daß*** sie wenigstens eine besondere Prüfeinheit umfaßt, die die Speicherung der besonderen Merkmale wenigstens einer einem Vergleicher zugeordneten Schwellenvorrichtung in die Speichereinheit (2) und einen Prüfsignalgenerator umfaßt, der ein Signal sendet, das auf der Höhe einer Obergrenze unter der Schwelle (Untergrenze über der Schwelle) solange gehalten wird, daß das Nichtauftreten eines Alarms geprüft werden kann, und das anschließend auf der Höhe einer Untergrenze über der Schwelle (Obergrenze unter der Schwelle) solange gehalten wird, um über einen logischen Eingang die Alarmauslösung zu prüfen, und das anschließend in aufeinanderfolgenden Stufen auf die andere Seite der Schwelle übergeht, indem geprüft wird, ob der Alarmzustand in einem vorbestimmten Zeitraum verschwindet.

3. Automatische Vorrichtung nach einem der Ansprüche 1 oder 2,
***dadurch gekennzeichnet, daß*** sie wenigstens eine besondere Prüfeinheit umfaßt, die die Speicherung der besonderen Merkmale wenigstens eines Teils (28) einer zur Übertragung von Werten einer gemessenen Größe dienenden Schutzkette in der Speichereinheit, eine Einrichtung (31, 32) zur Erzeugung von simulierten Meßwerten und einen Analogeingang (37) umfaßt, der als Vorrichtung zur Messung des Ausgangswerts dieses Teils (28) der Schutzkette dient.

4. Automatische Vorrichtung nach Anspruch 3,
***dadurch gekennzeichnet, daß*** die Einrichtung zur Erzeugung von simulierten Werten ein Wähler (32) ist, der Werte von Widerständen (31) wählt, und daß Wähler (33, 34, 35) von verschiedenen Teilen (28) einer Schutzkette die Prüfung dieser Teile (29) nacheinander gestatten.

5. Vorrichtung nach einem der vorhergehenden Ansprüche,
***dadurch gekennzeichnet, daß*** sie wenigstens eine besondere Prüfeinheit umfaßt, die die Speicherung der besonderen Merkmale wenigstens eines Teils (38) einer ein dynamisches Verhalten aufweisenden Schutzkette in der Speichereinheit, wenigstens einen Leiter, der den zu prüfenden Kettenteil mit einem Steuerübertragungskontakt (39) verbindet, der an die automatische Prüfkonsole angeschlossen werden kann, einen analogen Ausgang (42), der zur Erzeugung einer Prüfspannung dient, einen analogen Eingang (49), der als Echtzeitmeßvorrichtung dient, und logische Eingänge (43, 44) umfaßt, die als Echtzeitdetektoren für die dem zu prüfenden Kettenteil zugeordneten Vergleicher dient.

6. Vorrichtung nach einem der vorhergehenden Ansprüche,
***dadurch gekennzeichnet, daß*** eine Steuereinrichtung (39) der Prüfkonsole eine Schaltungsänderung in einem Teil (38) einer Schutzkette in einem die zu prüfende Anlage steuernden Schrank bewirkt.
